# EUROPEAN PATENT APPLICATION

(11) **EP 1 768 240 A1**
(43) Date of publication of application: **28.03.2007**
(21) Application number: 05741539.0
(22) Date of filing: 19.05.2005
(51) Int. Cl.: H02M 3/155

(54) **LEVEL SHIFT CIRCUIT AND SWITCHING REGULATOR USING THE SAME**

(30) Priority: 09.06.2004 JP 2004171038
(71) Applicant: ROHM CO., LTD., Kyoto-shi, Kyoto 615-8585 (JP)
(72) Inventor: SAKAI, Masaru C/O ROHM CO., LTD., Kyoto-Shi, Kyoto 6158585 (JP)
(74) Representative: Glawe, Delfs, Moll
(86) International application number: PCT/JP2005/009122
(87) International publication number: WO 2005/122373

(57) **Abstract**

In a level shift circuit 2, an NMOS transistor Q5 with the gate and source thereof short-circuited together is provided between a high-voltage power line to which a voltage BOOT is supplied and the input end n of an inverter circuit composed of a PMOS transistor Q1 and an NMOS transistor Q2, and an NMOS transistor Q6 with the gate and source thereof short-circuited together is provided between a low-voltage power line to which a voltage SW is supplied and the input end n of the inverter circuit composed of the PMOS transistor Q1 and the NMOS transistor Q2. Thus, the body diodes of the NMOS transistors Q5 and Q6 prevent the voltage waveform at the input end n from becoming blunt. This makes it possible to prevent malfunctioning of the level shift circuit.

## Description

### Technical Field

The present invention relates to a level shift circuit, and also relates to a switching regulator including a bootstrap type DC-DC converter that has a high input supply voltage and a low control supply voltage and that switches output transistors by use of a drive voltage higher than the input supply voltage.

### Background Art

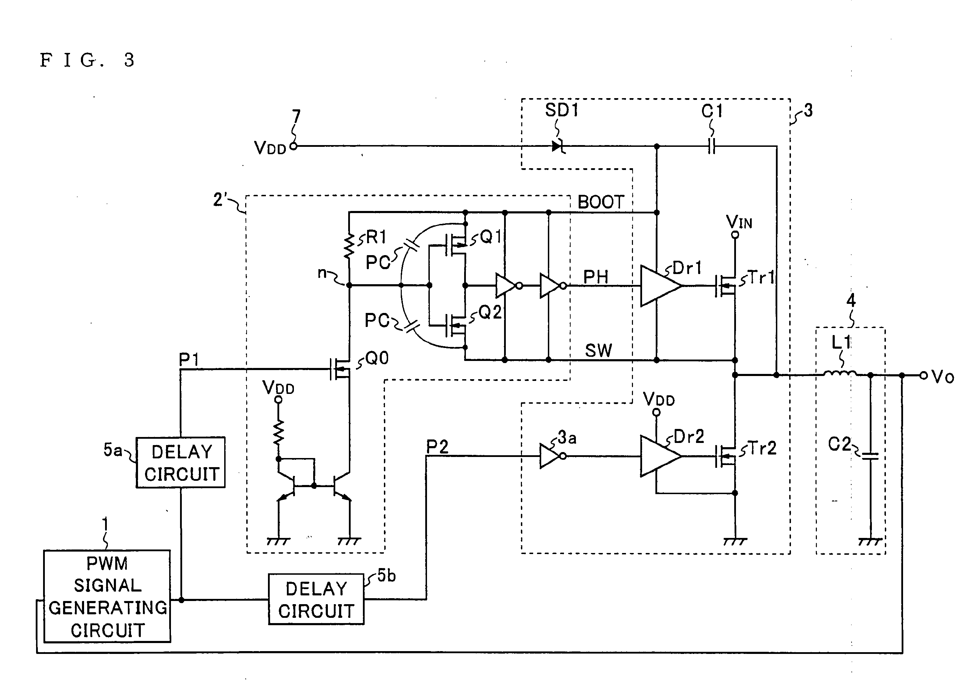

An example of the configuration of a conventional switching regulator is shown in FIG. 3. The switching regulator shown in FIG. 3 includes a bootstrap type DC-DC converter, and is composed of a PWM signal generating circuit 1, a level shift circuit 2', a bootstrap switching circuit 3, a smoothing circuit 4 and delay circuits 5a and 5b. Here, an input supply voltage V_{IN} is higher than a control supply voltage V_{DD'} and it is assumed that the input supply voltage V_{IN} is +25V and the control supply voltage V_{DD} is +5V.

The PWM signal generating circuit 1 generates a PWM signal according to an output voltage Vo and feeds the PWM signal to the delay circuits 5a and 5b. The delay circuit 5a delays the PWM signal outputted from the PWM signal generating circuit 1 and feeds the resulting signal as a PWM signal P1 to the level shift circuit 2'. The delay circuit 5b delays the PWM signal outputted from the PWM signal generating circuit 1 and feeds the resulting signal as a control pulse signal P2 to the bootstrap switching circuit 3. The supply voltage to the PWM signal generating circuit 1 and the delay circuits 5a and 5b is the control supply voltage V_{DD}. As compared with the PWM signal P1, the control pulse signal P2 rises a predetermined period earlier and falls a predetermined period later.

The level shift circuit 2' converts the PWM signal P1 into a high-voltage control pulse signal PH to feed it to the bootstrap switching circuit 3.

In the bootstrap switching circuit 3, a driver circuit Dr1 turns on and off an NMOS transistor Tr1 according to the high-voltage control pulse signal PH; on the other hand, the control pulse signal P2 is inverted by an inverter circuit 3a and, according to the inverted signal, a driver circuit Dr2 turns on and off an NMOS transistor Tr2.

When the NMOS transistor Tr1 is off and the NMOS transistor Tr2 is on, via a terminal 7 to which the control supply voltage V_{DD} is applied, a charging current flows into a capacitor C1 through a Schottky diode SD1, and thus the voltage across the capacitor C1 becomes about +5V. Thereafter, both the NMOS transistors Tr1 and Tr2 are kept off for a while, and then when the NMOS transistor Tr1 is on and the NMOS transistor Tr2 is off, the voltage SW at the node between the capacitor C1 and the NMOS transistor Tr1 becomes +25V and the voltage BOOT at the node between the capacitor C1 and the Schottky diode SD1 becomes about +30V. Thereafter, both the NMOS transistors Tr1 and Tr2 are kept off for a while, and then the NMOS transistor Tr1 is off and the NMOS transistor Tr2 is on again.

The voltage appearing between the node between the capacitor C1 and the Schottky diode SD1 and the node between the NMOS transistors Tr1 and Tr2 is fed, as a supply voltage, to the circuit provided in the stage succeeding the level shift circuit 2'.

The smoothing circuit 4 is a smoothing filter that is composed of an inductor L1 and a capacitor C2. The smoothing circuit 4 smoothes and then outputs, as the output voltage Vo, the voltage at the node between the NMOS transistors Tr1 and Tr2.

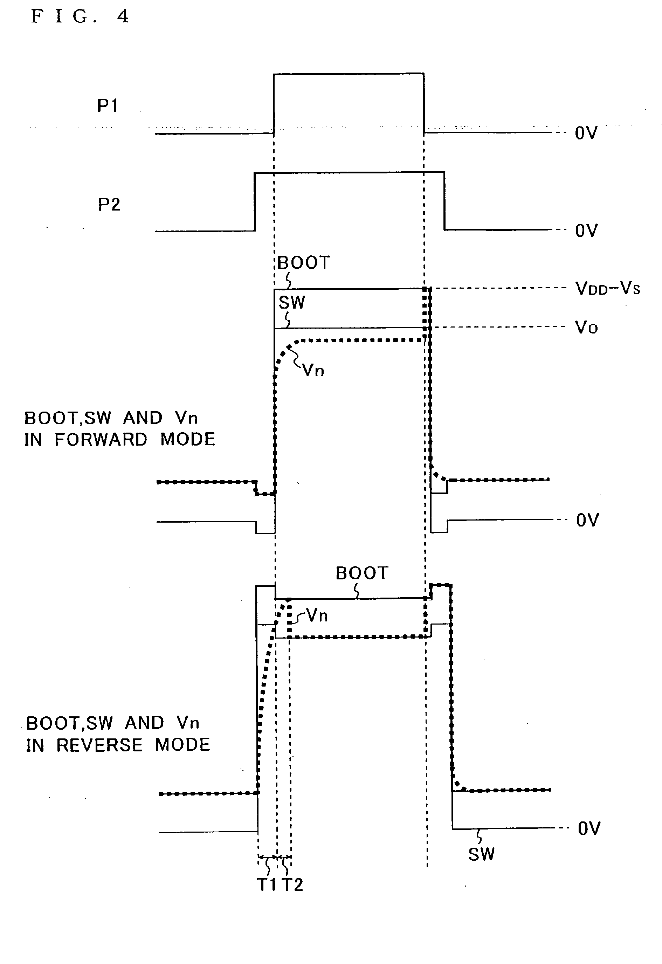

A switching regulator has two operating modes, namely a mode in which the output current flows from the switching regulator to the load (a forward mode) and a mode in which the output current flows from the load to the switching regulator (a reverse mode). In the switching regulator shown in FIG. 3, while both the NMOS transistors Tr1 and Tr2 are off, in the forward mode, a current flows through the body diode of the NMOS transistor Tr2; in the reverse mode, a current flows through the body diode of the NMOS transistor Tr1. Thus, the voltage waveforms observed at relevant points in the level shift circuit 2' are as shown in a time chart in FIG. 4. The symbol Vn in FIG. 4 represents the voltage at the node n between an NMOS transistor Q0 that receives the PWM signal P1 at the gate thereof and a resistor R1.

When the PWM signal P1 is low, the NMOS transistor Q0 is off, and thus the voltage Vn equals the voltage BOOT. When the PWM signal P1 is high, the NMOS transistor Q0 is on, and thus the voltage Vn equals the voltage SW.
Patent document 1: JP-A-2002-315311
Patent document 2: JP-A-2003-235251

### Disclosure of the Invention

### Problems to be Solved by the Invention

Inconveniently, however, the switching regulator shown in FIG. 3 has the following disadvantages. In the inverter that has the input end thereof at the node n and that is composed of a PMOS transistor Q1 and an NMOS transistor Q2, the gate-source parasitic capacitances PC of these transistors make the waveform of the voltage Vn blunt at the rising and trailing edges thereof as shown in FIG.4.

Thus, in the reverse mode, during the periods T1 and T2 where the waveform of the voltage Vn is blunt, the output of the inverter composed of the PMOS transistor Q1 and the NMOS transistor Q2 may improperly be inverted, leading to malfunctioning. Specifically, during the period T1, the difference between the voltages BOOT and Vn may become so large as to turn high the output of the inverter composed of the PMOS transistor Q1 and the NMOS transistor Q2, and in addition, during the period T2, the difference between the voltages SW and Vn may become so large as to turn low the output of the inverter composed of the PMOS transistor Q1 and the NMOS transistor Q2. Moreover, during the period T1, the PMOS transistor Q1 may fall into withstand voltage failure between the gate and source thereof, thus reducing reliability. These disadvantages are particularly remarkable, for example, in the following cases: to make the switching regulator capable of coping with a larger current, the PMOS transistor Q1 and the NMOS transistor Q2 are made larger, with the result that the parasitic capacitances PC are accordingly higher; to reduce power consumption, the resistors R1 is given a higher resistance, with the result that the time constant attributable to the parasitic capacitances PC and the resistors R1 is accordingly greater; and the on-period of the PWM signal P1 is short.

In view of the disadvantages described above, it is an object of the present invention to provide a level shift circuit that operates with reduced likeliness of malfunctioning, and to provide a switching regulator therewith.

### Means for Solving the Problem

To achieve the above object, a level shift circuit according to the present invention that receives a first pulse signal and generates, according to the first pulse signal, a second pulse signal of which the high level is higher than the high level of the first pulse signal is provided with: a high supply voltage feed line; a low supply voltage feed line; an inverter circuit that operates from, as a supply voltage thereto, a voltage between the high supply voltage feed line and the low supply voltage feed line; a first diode that has the anode thereof connected to the input end of the inverter circuit and that has the cathode thereof connected to the high supply voltage feed line; and a second diode that has the cathode thereof connected to the input end of the inverter circuit and that has the anode thereof connected to the low supply voltage feed line.

With the configuration described above, when, according to the first pulse signal, the potential at the input end is substantially equal to the high supply voltage feed line potential, even if there appears a rising or trailing edge in the high supply voltage feed line potential, the first diode prevents the difference between the high supply voltage feed line potential and the potential at the input end from becoming equal to or more than the forward voltage of the first diode. This prevents the waveform of the potential at the input end from becoming blunt. On the other hand, when, according to the first pulse signal, the potential at the input end is equal to the low supply voltage feed line potential, the difference between the high supply voltage feed line potential and the potential at the input end is kept equal to the forward voltage of the second diode. This prevents the waveform of the potential at the input end from becoming blunt. Thus, it is possible to reduce the likeliness of malfunctioning resulting from the waveform of the potential at the input end becoming blunt and hence the output of the inverter becoming improperly inverted.

The body diode of a MOS transistor has a small cross-sectional area and hence has a low parasitic capacitance. Thus, by using the body diode of a MOS transistor as each of the first and second diodes, it is possible to enhance the effect of preventing blunting of the waveform of the input end voltage in the above-mentioned inverter circuit. It is therefore preferable to use the body diode of a MOS transistor as each of the first and second diodes.

The level shift circuit described above can be applied to switching regulators including a bootstrap type DC-DC converter.

### Advantages of the Invention

According to the present invention, it is possible to realize a level shift circuit that operates with reduced likeliness of malfunctioning, and to provide a switching regulator therewith.

### Brief Description of Drawings

[FIG. 1] A diagram showing an example of the configuration of a switching regulator according to the present invention;
[FIG. 2] A time chart of the voltage waveforms observed at relevant points in the level shift circuit included in the switching regulator shown in FIG. 1;
[FIG. 3] A diagram showing an example of the configuration of a conventional switching regulator; and
[FIG. 4] A time chart of the voltage waveforms observed at relevant points in the level shift circuit included in the switching regulator shown in FIG. 3.

### List of Reference Symbols

- 1: PWM signal generating circuit
- 2: Level shift circuit
- 3: Bootstrap switching circuit
- 4: Smoothing circuit
- 6: Simultaneous-on preventing circuit
- Q5, Q6: NMOS transistor

### Best Mode for Carrying Out the Invention

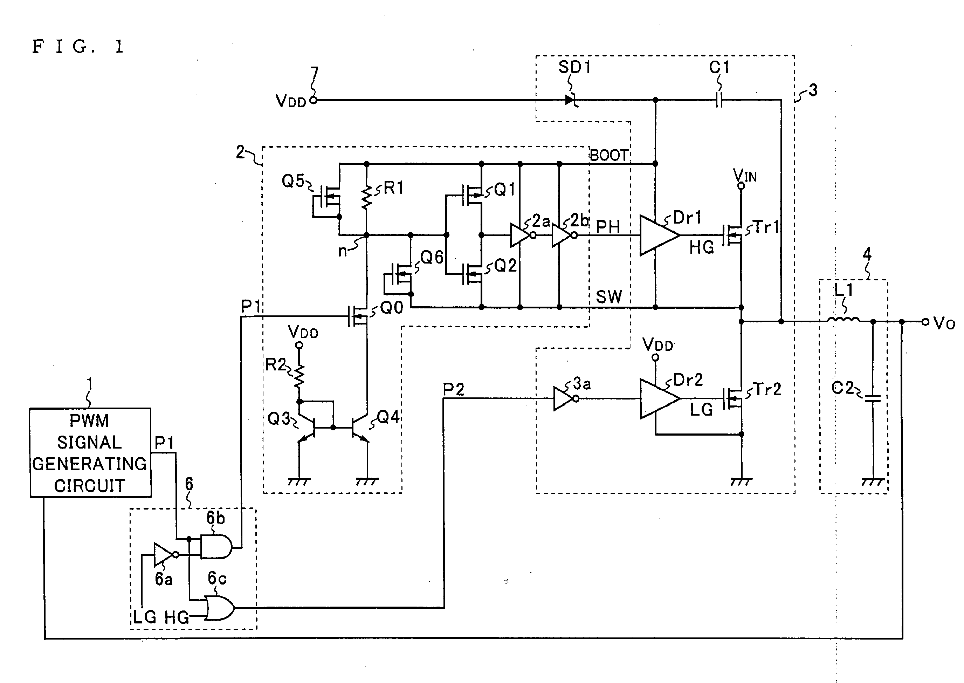

Hereinafter; an embodiment of the present invention will be described with reference to the accompanying drawings. An example of the configuration of a switching regulator according to the present invention is shown in FIG. 1. In FIG. 1, such parts as are found also in FIG. 3 are identified with common reference numerals. The switching regulator shown in FIG. 1 includes a bootstrap type DC-DC converter, and is composed of a PWM signal generating circuit 1, a level shift circuit 2, a bootstrap switching circuit 3, a smoothing circuit 4 and a simultaneous-on preventing circuit 6.

In the switching regulator shown in FIG. 1, the circuit configuration except for the level shift circuit 2 and the simultaneous-on preventing circuit 6 is the same as that of the switching regulator shown in FIG. 3 and described previously as a conventional example, and thus no description thereof will be repeated. In the following description, the level shift circuit 2 and the simultaneous-on preventing circuit 6, which characterize the present invention, will be described. The simultaneous-on preventing circuit 6 is composed of an inverter circuit 6a, an AND gate 6b and an OR gate 6c. The inverter circuit 6a receives the output LG of a driver circuit Dr2. That is, the input terminal of the inverter circuit 6a is connected to the node between the output terminal of the driver circuit Dr2 and the gate of an NMOS transistor Tr2. The output terminal of the inverter circuit 6a is connected to the second input terminal of the AND gate 6b. The AND gate 6b and the OR gate 6c receive, at their respective first input terminals, the PWM signal P1 outputted from the PWM signal generating circuit 1. That is, the first input terminals of the AND gate 6b and of the OR gate 6c are connected to the output end of the PWM signal generating circuit 1. The OR gate 6c receives, at the second input terminal thereof, the output HG of the driver circuit Dr1. That is, the second input terminal of the OR gate 6c is connected to the node between the output terminal of the driver circuit Dr1 and the gate of an NMOS transistor Tr1. The output terminal of the AND gate 6b is connected to the gate of an NMOS transistor Q0 included in the level shift circuit 2, and the output terminal of the OR gate 6c is connected to the input terminal of an inverter circuit 3a included in the bootstrap switching circuit 3.

The simultaneous-on preventing circuit 6 configured as described above outputs the PWM signal P1 to the gate of the NMOS transistor Q0 included in the level shift circuit 2, and also outputs a control pulse signal P2 to the input terminal of the inverter circuit 3a included in the bootstrap switching circuit 3. Here, the control pulse signal P2 is a signal that, as compared with the PWM signal P₁, rises a predetermined period earlier and falls a predetermined period later.

The level shift circuit 2 is composed of: the NMOS transistor Q0; a resistor R1; a current mirror circuit made up of NPN transistors Q3 and Q4; a resistor R2 that serves as a current source for supplying a current to the current mirror circuit; an inverter circuit made up of a PMOS transistor Q1 and an NMOS transistor Q2; inverter circuits 2a and 2b; and NMOS transistors Q5 and Q6. The inverter circuits are each connected between a power line to which a voltage BOOT is supplied and a power line to which a voltage SW is supplied, and both operate from, as a supply voltage thereto, the voltage between these power lines.

The drain of the NMOS transistor Q0 is connected via the resistor R1 to the power line to which the voltage BOOT is supplied. The source of the NMOS transistor Q0 is connected to the output of the current mirror circuit composed of the NPN transistors Q3 and Q4. The node n between the resistor R1 and the NMOS transistor Q0 is the input end of the inverter circuit composed of the PMOS transistor Q1 and the NMOS transistor Q2. The output of the inverter circuit composed of the PMOS transistor Q1 and the NMOS transistor Q2 is inverted by the inverter circuit 2a, and then the output of the inverter circuit 2a is inverted by the inverter circuit 2b so as to become a pulse control signal PH.

Moreover, an NMOS transistor Q5 with the gate and source thereof short-circuited together is provided between the node n and the power line to which the voltage BOOT is supplied, and an NMOS transistor Q6 with the gate and source thereof short-circuited together is provided between the node n and the power line to which the voltage SW is supplied.

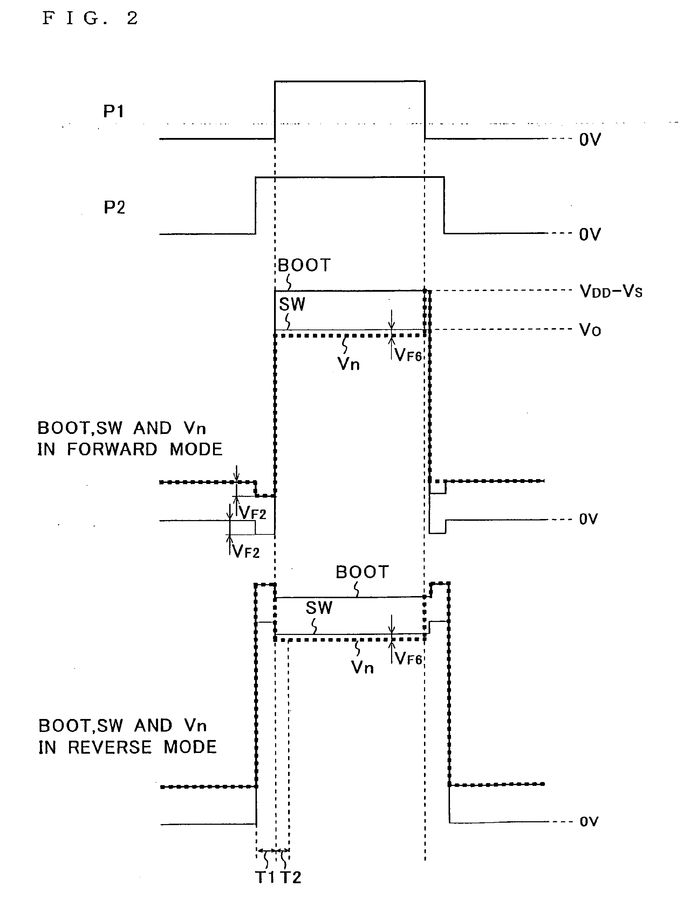

A time chart of the voltage waveforms observed at relevant points in the level shift circuit 2 is shown in FIG. 2. The symbol Vn in FIG. 2 represents the voltage at the node n between the NMOS transistor Q0 that receives the PWM signal P1 at the gate thereof and the resistor R1. The symbol Vs in FIG. 2 represents the forward voltage of the Schottky diode SD1. The symbol V_{F2} in FIG. 2 represents the forward voltage of the body diode of the NMOS transistor Q2, and the symbol V_{F6} in FIG. 2 represents the forward voltage of the body diode of the NMOS transistor Q6.

First, a description will be given of the forward mode. During the period where both the PWM signal P1 and the control pulse signal P2 are low (=0V), and during the period T1 where, after the rise of the control pulse signal P2, the PWM signal P1 is low (=OV) and the control pulse signal P2 is high, the voltage Vn equals the voltage BOOT. During the period where both the PWM signal P1 and the control pulse signal P2 are high, the body diode of the NMOS transistor Q6 keeps the difference between the voltages SW and Vn equal to the forward voltage V_{F6} of the body diode of the NMOS transistor Q6. This prevents the waveform of the voltage Vn from becoming blunt. Then, when the PWM signal P1 falls, the voltage Vn is first raised to the high level of the voltage BOOT (its value as observed during the period where both the PWM signal P1 and the control pulse signal P2 are high) and is then lowered so as to be equal to the low level of the voltage BOOT (its value as observed during the period where both the PWM signal P1 and the control pulse signal P2 are low).

Next, a description will be given of the reverse mode. During the period T1, the body diode of the NMOS transistor Q5 prevents the difference between the voltages BOOT and Vn from becoming equal to and more than the forward voltage of the body diode of the NMOS transistor Q5. This prevents the waveform of the voltage Vn from becoming blunt even when the voltage Vn rises as the voltage BOOT rises, and also prevents withstand voltage failure between the gate and source of the PMOS transistor Q1,contributing to enhanced reliability.

Moreover, during the period T2 (during which, conventionally, the voltage Vn becomes higher than the voltage SW), the body diode of the NMOS transistor Q6 keeps the difference between the voltages SW and Vn equal to the forward voltage V_{F6} of the body diode of the NMOS transistor Q6, and thereby prevents the waveform of the voltage Vn from becoming blunt. This eliminates the likeliness of malfunctioning resulting from the output of the inverter composed of the PMOS transistor Q1 and the NMOS transistor Q2 becoming improperly inverted. Furthermore, during the period T1, the likeliness of withstand voltage failure between the gate and source of the PMOS transistor Q1 is also eliminated, contributing to enhanced reliability.

Instead of the NMOS transistors Q5 and Q6, there may be provided, respectively, an "ordinary" diode that has the anode thereof connected to the node n and that has the cathode thereof connected to the power line to which the voltage BOOT is supplied and an "ordinary diode that has the cathode thereof connected to the node n and that has the anode thereof connected to the power line to which the voltage SW is supplied. This too helps alleviate the blunting of the waveform of the voltage Vn. As compared with the body diodes of NMOS transistors, however, the ordinary diodes have larger cross-sectional areas and hence have larger parasitic capacitances. Thus, these diode have less effect of alleviating the blunting of the waveform of the voltage Vn.

### Industrial Applicability

A level shift circuit according to the present invention can be applied to switching regulators and the like. These switching regulators can be applied to power supplies for electric devices in general.

## Claims

1. A level shift circuit that receives a first pulse signal and generates, according to the first pulse signal, a second pulse signal of which a high level is higher than a high level of the first pulse signal, the level shift circuit comprising:
a high supply voltage feed line;
a low supply voltage feed line;
an inverter circuit that operates from, as a supply voltage thereto, a voltage between the high supply voltage feed line and the low supply voltage feed line;
a first diode that has an anode thereof connected to an input end of the inverter circuit and that has a cathode thereof connected to the high supply voltage feed line; and
a second diode that has a cathode thereof connected to the input end of the inverter circuit and that has an anode thereof connected to the low supply voltage feed line.

2. The level shift circuit of claim 1,
wherein a body diode of a MOS transistor is used as each of the first and second diodes.

3. A switching regulator comprising a bootstrap type DC-DC converter,
wherein the bootstrap type DC-DC converter includes the level shift circuit of claim 1.

4. A switching regulator comprising a bootstrap type DC-DC converter,
wherein the bootstrap type DC-DC converter includes the level shift circuit of claim 2.
